# FASCICULE DE BREVET EUROPEEN

(11) **EP 2 939 277 B1**
(45) Date de publication et mention de la délivrance du brevet: **17.07.2019**
(21) Numéro de dépôt: 13821898.7
(22) Date de dépôt: 27.12.2013
(51) Int. Cl.: H01L 33/08, H01L 33/18, H01L 33/24, H01L 31/0352, H01L 31/0304, H01L 33/00, H01L 33/04, H01L 33/32, H01L 31/0693, H01L 31/075

(54) **DISPOSITIF OPTOELECTRONIQUE A MICROFILS OU NANOFILS**
OPTOELEKTRONISCHES BAUTEIL MIT MICRO- ODER NANOSTÄBCHEN
OPTOELECTRONIC DEVICE HAVING MICRO-RODS OR NANORODS

(30) Priorité: 28.12.2012 FR 1262928
(43) Date de publication de la demande: 04.11.2015
(73) Titulaire: Commissariat à l'Energie Atomique et aux Energies Alternatives, 75015 Paris (FR); Aledia, 38040 Grenoble Cedex (FR)
(72) Inventeur: DUSSAIGNE, Amélie, F-38260 SAINT HILAIRE DE LA COTE (FR); MILLION, Alain, F-38000 Grenoble (FR); BAVENCOVE, Anne-Laure, F-38000 Grenoble (FR)
(74) Mandataire: Cabinet Beaumont
(86) Numéro de dépôt international: PCT/FR2013/053274
(87) Numéro de publication internationale: WO 2014/102514

(56) Documents cités:
- WO-A1-2010/005381
- WO-A2-2012/054477
- WO-A2-2012/156620
- DE-A1-102010 012 711
- FR-A1- 2 964 796
- US-A1- 2011 309 382
- US-A1- 2012 068 153
- US-A1- 2012 217 474
- US-B2- 7 829 443
- ANJIA GU ET AL: "Design and growth of III-V nanowire solar cell arrays on low cost substrates", 35TH IEEE PHOTOVOLTAIC SPECIALISTS CONFERENCE (PVSC), 20-25 JUNE 2010, HONOLULU, HI, USA, IEEE, PISCATAWAY, NJ, USA, 20 juin 2010 (2010-06-20), pages 2034-2037, XP031784502, ISBN: 978-1-4244-5890-5
- ROBIN I C ET AL: "Growth and characterization of ZnO nanowires on p-type GaN", MICROELECTRONICS JOURNAL, MACKINTOSH PUBLICATIONS LTD. LUTON, GB, vol. 40, no. 2, 2 février 2009 (2009-02-02), pages 250-252, XP025925065, ISSN: 0026-2692, DOI: 10.1016/J.MEJO.2008.07.015 [extrait le 2008-08-30]
- BAVENCOVE A-L ET AL: "Light emitting diodes based on GaN core/shell wires grown by MOVPE on n-type Si substrate", ELECTRONIC LETTERS, THE INSTITUTION OF ENGINEERING AND TECHNOLOGY, vol. 47, no. 13, 23 juin 2011 (2011-06-23) , pages 765-767, XP006039074, ISSN: 1350-911X, DOI: 10.1049/EL:20111242
- A-L BAVENCOVE ET AL: "Submicrometre resolved optical characterization of green nanowire-based light emitting diodes", NANOTECHNOLOGY, IOP, BRISTOL, GB, vol. 22, no. 34, 28 juillet 2011 (2011-07-28), page 345705, XP020208850, ISSN: 0957-4484, DOI: 10.1088/0957-4484/22/34/345705

## Description

La présente demande de brevet revendique la priorité de la demande de brevet français FR12/62928.

### Domaine

La présente description concerne de façon générale les dispositifs optoélectroniques comprenant des microfils ou nanofils semiconducteurs et leurs procédés de fabrication.

Par dispositifs optoélectroniques, on entend des dispositifs adaptés à effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés à des applications photovoltaïques.

### Exposé de l'art antérieur

On s'intéresse plus particulièrement ici à l'amélioration des dispositifs optoélectroniques à microfils ou nanofils de types radiaux, également appelés microfils ou nanofils en coeur/coquille, comprenant une zone active formée à la périphérie d'un microfil ou nanofil.

Les microfils ou les nanofils considérés ici comprennent un matériau semiconducteur comportant majoritairement un élément du groupe III et un élément du groupe V (par exemple du nitrure de gallium GaN), appelé par la suite composé III-V.

De tels dispositifs sont par exemple décrits dans les demandes de brevet français non publiées N°12/58729 déposée le 18 septembre 2012 et N°12/60232 déposée le 26 octobre 2012.

Les documents WO 2012/054477 A2 et DE 10 2010 012 711 A1 décrivent des dispositifs de l'art antérieur.

### Résumé

Ainsi, on prévoit ici un dispositif optoélectronique comprenant des microfils ou nanofils dont chacun comprend une alternance de portions passivées et de portions actives, les portions actives étant entourées d'une couche active, les couches actives ne s'étendant pas sur les portions passivées.

Selon un mode de réalisation, les hauteurs des portions actives sont différentes.

Selon un mode de réalisation, les hauteurs des portions actives sont égales.

Selon un mode de réalisation, au moins l'une des portions actives a une hauteur supérieure ou égale à 4 µm.

Selon un mode de réalisation, au moins l'une des portions actives a une hauteur strictement inférieure à 5 µm.

Selon un mode de réalisation, la hauteur de chaque portion passivée intercalée entre deux portions actives est comprise entre 200 nm et 10 µm.

Selon un mode de réalisation, chaque portion passivée est entourée d'une couche de matériau diélectrique ayant une épaisseur comprise entre une monocouche atomique et 10 nm.

Selon un mode de réalisation, les portions passivées et actives ont le même diamètre moyen.

Selon un mode de réalisation, les portions passivées et actives ont des diamètres différents.

Selon un mode de réalisation, les portions passivées comprennent un composé III-V dopé, les portions actives comprenant majoritairement un composé III-V non dopé ou moins fortement dopé que les portions passivées.

Selon un mode de réalisation, le composé III-V est un composé III-N, notamment choisi parmi le groupe comprenant le nitrure de gallium, le nitrure d'aluminium, le nitrure d'indium, le nitrure de gallium et d'indium, le nitrure de gallium et d'aluminium, le nitrure d'aluminium et d'indium et le nitrure de gallium, d'aluminium et d'indium.

Selon un mode de réalisation, le composé III-V est du nitrure de gallium et le dopant du composé III-V dopé est du silicium.

Selon un mode de réalisation, la portion la plus éloignée du support est une portion passivée.

Selon un mode de réalisation, chaque couche active comprend une structure à puits quantiques multiples ou simple couche.

Il est également prévu un procédé de fabrication d'un dispositif optoélectronique tel que défini précédemment, dans lequel les portions passivées sont réalisées dans un réacteur avec des premières proportions de précurseurs de composés III-V et un dopant tel que le silicium, et les portions actives sont réalisées dans le même réacteur dans des conditions différentes de croissance et avec un taux de dopant plus faible que celui des portions passivées ou nul.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 est une coupe, partielle et schématique, d'un exemple de dispositif optoélectronique à microfils ou nanofils ;
les figures 2 et 3 sont des coupes, partielles et schématiques, de modes de réalisation d'un dispositif optoélectronique à microfils ou nanofils ; et
les figures 4A à 4H sont des coupes, partielles et schématiques, de structures obtenues à des étapes successives d'un mode de réalisation du procédé de fabrication du dispositif optoélectronique de la figure 2.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, la troisième dimension, appelée dimension majeure, étant au moins égale à 1 fois, de préférence au moins 5 fois, encore plus préférentiellement au moins 10 fois, la plus grande des dimensions mineures. Dans certains modes de réalisation, les dimensions mineures peuvent être inférieures ou égales à environ 1000 nm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

La section droite des fils peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil.

Les fils peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Dans certains modes de réalisation, les fils peuvent comprendre un dopant. A titre d'exemple, pour des composés III-V, le dopant peut être choisi parmi le groupe comprenant un dopant de type P du groupe II, par exemple du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

Les fils sont formés sur une face d'un substrat. Le substrat peut correspondre à une structure monobloc ou correspondre à une couche recouvrant un support constitué d'un autre matériau. Le substrat est, par exemple, un substrat semiconducteur, tel qu'un substrat en silicium, en germanium, en carbure de silicium, en un composé III-V, tel que du GaN ou du GaAs, un substrat en ZnO. Le substrat peut être en un matériau conducteur, par exemple en métal, ou en un matériau isolant, par exemple en saphir, en verre ou en céramique. De préférence, le substrat est en silicium, notamment en silicium monocristallin ou polycristallin.

Un traitement peut être appliqué au substrat pour favoriser la croissance des fils, notamment à des emplacements déterminés. En outre, le traitement peut favoriser la croissance des fils selon une polarité donnée. Un exemple de traitement consiste à recouvrir le substrat d'une couche, appelée couche de nucléation, d'un matériau favorisant la croissance des fils. Un autre exemple de traitement comprend le dépôt sur le substrat ou sur la couche de nucléation d'une couche d'un matériau diélectrique, la formation d'ouvertures dans la couche du matériau diélectrique pour exposer des parties du substrat ou de la couche de nucléation et la croissance des fils sur les parties du substrat ou de la couche de nucléation exposées, comme cela est décrit dans le document US 7 829 443. Un autre exemple de traitement comprend le dépôt sur le substrat d'une couche comprenant des portions d'un matériau favorisant chacune la croissance d'un fil d'un composé III-V selon la polarité de l'élément du groupe V séparées par une région d'un matériau favorisant la croissance du composé III-V selon la polarité de l'élément du groupe III, comme cela est décrit dans la demande de brevet non publiée N°12/58729. Un autre exemple de traitement comprend la formation, sur le substrat, de plots d'un matériau favorisant la croissance des fils et la réalisation d'un traitement de protection des parties de la surface du substrat non recouvertes par les plots pour y empêcher la croissance de fils, comme cela est décrit dans la demande de brevet non publiée N°12/60232.

Le procédé de croissance des fils peut être un procédé du type dépôt chimique en phase vapeur (CVD, sigle anglais pour Chemical Vapor Deposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Deposition), les procédés hydrothermiques, la pyrolise d'aérosol liquide ou l'électrodépôt.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃) ou le diméthylhydrazine (UDMH).

Selon un mode de réalisation de l'invention, dans certaines phases de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄). La présence du précurseur de l'élément supplémentaire conduit à l'incorporation de l'élément supplémentaire dans le composé III-V pour doper ce composé III-V mais également à la formation d'une couche d'un matériau diélectrique principalement constitué de l'élément supplémentaire et de l'élément du groupe V sur les flancs latéraux des cristaux en croissance du composé III-V. La concentration de l'élément supplémentaire dans le composé III-V est comprise entre 10¹⁸ et 10²¹ atomes/cm³, par exemple de l'ordre de 10²⁰ atomes/cm³. La couche du matériau diélectrique a une épaisseur comprise entre une monocouche atomique et 10 nm. Dans le cas où le composé III-V est du GaN et l'élément supplémentaire est du silicium, le GaN est fortement dopé de type N et sera appelé ici n⁺GaN et la couche de matériau diélectrique est du nitrure de silicium SiN, de formule générale SiₓN_{y}, où x et y sont des nombres compris entre 1 et 4, par exemple sous forme stoechiométrique Si₃N₄.

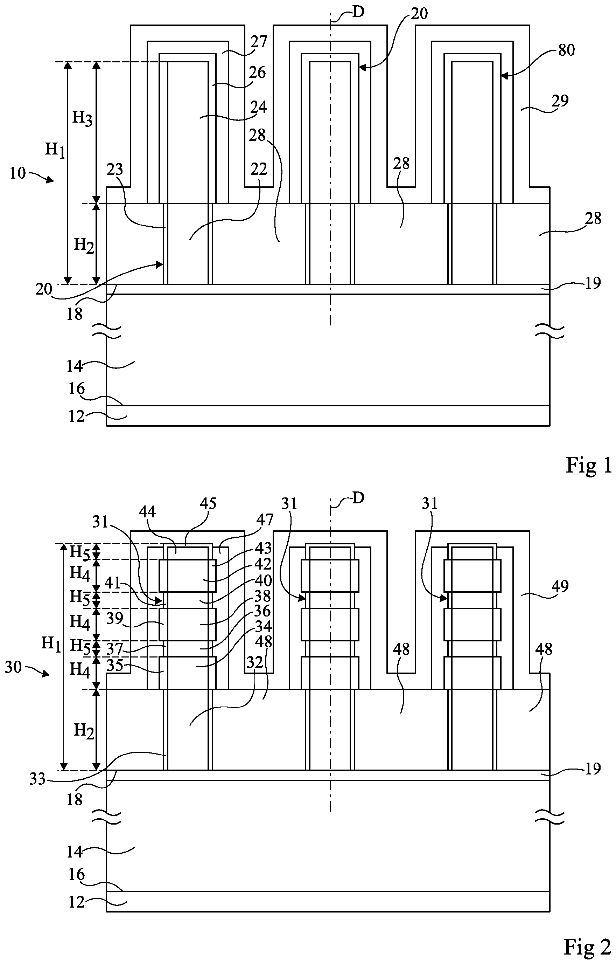

La figure 1 est une coupe, partielle et schématique, d'un dispositif optoélectronique 10 réalisé à partir de fils tels que décrits précédemment et adapté à l'émission ou à la réception d'un rayonnement électromagnétique.

Le dispositif 10 comprend, du bas vers le haut en figure 1 :
une première électrode de polarisation 12 ;
un substrat 14, par exemple semiconducteur, comprenant des faces parallèles 16 et 18, la face 16 étant au contact de l'électrode 12 et la face 18 étant traitée de façon à favoriser la croissance de fils de façon organisée, notamment de l'une des façons décrites précédemment. Ce traitement est représenté de façon schématique en figure 1 par une région 19 en surface du substrat 14 ;
des fils 20 (trois fils étant représentés) de hauteur H₁, chaque fil comprenant une portion inférieure 22 de hauteur H₂, en contact avec la face 18, et une portion supérieure 24 de hauteur H₃ ;
une couche passivante 23 recouvrant la périphérie de chaque portion inférieure 22 ;
une couche active 26 recouvrant chaque portion supérieure 24 ;
une couche semiconductrice 27 recouvrant chaque couche active 26 ;
des portions isolantes 28 recouvrant la face 18 entre les fils 20 sur au moins la hauteur H₂ ; et
une couche de seconde électrode 29 recouvrant les couches semiconductrices 27 et les portions isolantes 28.

Le substrat 14 est, par exemple, un substrat semiconducteur, tel qu'un substrat en silicium. Le substrat 14 peut être dopé d'un premier type de conductivité, par exemple dopé de type N.

La face 16 peut être traitée de façon à permettre la formation d'un bon contact électrique avec l'électrode 12, de préférence de type ohmique et à faible résistance de contact.

L'électrode 12 peut correspondre à une couche conductrice qui s'étend sur la face 16 du substrat 14. Le matériau formant l'électrode 12 est, par exemple, du siliciure de nickel (NiSi), de l'aluminium (Al), du siliciure d'aluminium (AlSi), du titane (Ti) ou du siliciure de titane (TiSi). Cette couche peut être recouverte d'une autre couche métallique, par exemple de l'or, du cuivre ou des eutectiques (Ti/Ni/Au ou Sn/Ag/Cu) en cas de brasure.

Chaque fil 20 est une structure semiconductrice allongée selon un axe D sensiblement perpendiculaire à la face 18. Chaque fil 20 peut avoir une forme générale cylindrique allongée à base hexagonale. Le diamètre moyen de chaque fil 20 peut être compris entre 50 nm et 2,5 µm et la hauteur H₁ de chaque fil 20 peut être comprise entre 1 µm et 50 µm. Les axes de deux fils adjacents peuvent être distants de 0,5 µm à 10 µm et de préférence de 1 à 3 µm.

La portion inférieure 22 de chaque fil est principalement constituée d'un composé III-N, par exemple du nitrure de gallium, dopé d'un premier type de conductivité, par exemple au silicium. Le pourtour de la portion inférieure 22 est recouvert par la couche de diélectrique 23, par exemple du SiN, sur la hauteur H₂. La hauteur H₂ peut être comprise entre 500 nm et 25 µm. La couche de matériau diélectrique 23 a une épaisseur comprise entre une monocouche atomique et 10 nm.

La portion supérieure 24 de chaque fil est, par exemple, au moins partiellement réalisée dans un composé III-N, par exemple du GaN. La portion supérieure 24 peut être dopée du premier type de conductivité, par exemple de type N, ou ne pas être intentionnellement dopée.

Dans le cas d'un fil composé principalement de GaN, la structure cristalline du fil peut être du type wurtzite, le fil s'étendant selon l'axe C.

La couche active 26 est la couche depuis laquelle est émise la majorité du rayonnement fourni par le dispositif 10 ou dans laquelle est capturée la majorité du rayonnement par le dispositif. Selon un exemple, la couche active 26 peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche semiconductrice 27 permet la formation d'une jonction P-N ou P-I-N avec la couche active 26 et/ou la portion 24. Elle permet l'injection de trous dans la couche active 26 via l'électrode 29. La couche semiconductrice 27 est, par exemple, au moins partiellement réalisée dans un composé III-N, par exemple du GaN dopé du type de conductivité opposé à celui des portions 22 et 24, par exemple dopé de type P.

Entre la couche active 26 et la couche semiconductrice 27, on peut prévoir au moins une couche d'interface non représentée, à savoir une couche de blocage d'électrons formée d'un alliage ternaire, par exemple en nitrure de gallium et d'aluminium (AlGaN) ou en nitrure d'indium et d'aluminium (AlInN) de même type de conductivité que la couche semiconductrice 27.

Les portions isolantes 28 sont, par exemple, en oxyde de silicium ou en nitrure de silicium.

La deuxième électrode 29 est adaptée à assurer la polarisation électrique de chaque jonction P-N et à laisser passer le rayonnement électromagnétique émis ou reçu par le dispositif. Le matériau formant l'électrode 29 peut être un matériau transparent et conducteur tel que de l'oxyde d'indium-étain (ou ITO, acronyme anglais pour Indium Tin Oxide) ou de l'oxyde de zinc dopé à l'aluminium.

Le dispositif décrit en figure 1 fonctionne convenablement mais présente divers inconvénients, notamment du fait que la couche active 26 tend à ne pas se former de façon uniforme sur les flancs latéraux de la portion de fil 24 sur toute la hauteur H₃. En particulier, dans le cas où la couche active 26 comprend des couches de InGaN, on constate une variation de la concentration d'indium dans les couches de InGaN le long de la partie radiale de la couche active et/ou une variation de l'épaisseur des couches de InGaN le long de la partie radiale de la couche active. Ceci se traduit par une variation de la longueur d'onde du rayonnement émis le long de la partie radiale de la couche active. Plus précisément, la partie radiale de chaque couche de InGaN est plus épaisse aux extrémités qu'en partie centrale. En outre, la concentration en indium est plus élevée aux extrémités qu'en partie centrale de la partie radiale de chaque couche de InGaN. Ceci se traduit par une longueur d'onde plus élevée du rayonnement émis aux extrémités qu'en partie centrale de la partie radiale de chaque couche active 26. Par exemple, pour une hauteur H₃ de l'ordre de 5 µm, et une couche active comprenant des puits quantiques multiples comprenant une alternance de couches de GaN et de InGaN ayant des épaisseurs respectives visées de 8 nm et de 2,5 nm en moyenne, les inventeurs ont observé que, dans la partie radiale de chaque couche de InGaN, la concentration en indium était moins importante en partie centrale qu'aux extrémités et que l'épaisseur était proche de 2 nm en partie centrale et de 3,5 nm aux extrémités, ce qui correspondait à une longueur d'onde d'émission d'environ 400 nm en partie centrale et de 450 nm aux extrémités.

Il est dans ce cas difficile d'obtenir un spectre d'émission ou d'absorption étroit autour d'une unique longueur d'onde.

Cette difficulté est, en outre, accrue par le fait que la longueur d'onde du rayonnement émis à l'extrémité axiale de la couche active est généralement plus élevée que celle émise en partie radiale, notamment en raison du fait que la croissance des couches sur le sommet et sur les flancs latéraux de la portion supérieure 24 se fait sur des plans cristallographiques différents.

Toutefois, le dispositif optoélectronique de la figure 1 ne permet pas non plus l'obtention d'un spectre d'émission ou d'absorption qui soit large et uniforme, en particulier proche de celui de la lumière blanche, puisque les longueurs d'onde d'émission et les contributions des différentes parties de la couche active au spectre total ne peuvent pas être sélectionnées indépendamment les unes des autres.

Ainsi, un objet d'un mode de réalisation est de pallier tout ou partie des inconvénients des dispositifs optoélectroniques, notamment à microfils ou nanofils, et de leurs procédés de fabrication décrits précédemment.

Un autre objet d'un mode de réalisation est que le dispositif optoélectronique à microfils ou nanofils soit à spectre large et uniforme ou à spectre d'émission ou d'absorption étroit.

Un autre objet d'un mode de réalisation est d'augmenter la qualité d'émission ou d'absorption du dispositif optoélectronique à microfils ou nanofils.

Les inventeurs ont mis en évidence que lorsque la hauteur d'une portion active est inférieure à un seuil de hauteur d'environ H_{S}, les phénomènes d'inégalité d'épaisseur et/ou d'inégalité de concentration d'éléments de la couche active ne sont sensiblement pas significatifs, de sorte que la longueur d'onde d'émission ou d'absorption est sensiblement constante le long de la couche active. Les inventeurs ont mis en évidence que lorsque la hauteur d'une portion active est supérieure à ce seuil de hauteur H_{S}, les phénomènes d'inégalité d'épaisseur et/ou d'inégalité de concentrations d'éléments de la couche active sont suffisamment importants pour que les longueurs d'onde d'émission ou d'absorption varient de plus de 1 % le long de la partie radiale de la couche active, ce pourcentage augmentant avec la longueur de la portion active.

Le seuil de hauteur H_{S} dépend notamment du diamètre du fil, de sa hauteur, de la densité de fils, des conditions de croissance des fils, des matériaux constituant les fils, et de l'orientation des plans sur lesquels sont formées les couches actives.

De préférence, le seuil de hauteur H_{S} est compris entre 0,1 µm et 10 µm. Pour l'ensemble formé d'un fil GaN recouvert de couches actives à base d'InGaN ayant un diamètre moyen d'environ 2 µm, le seuil de hauteur H_{S} est compris entre 4 et 5 µm.

Dans les modes de réalisation décrits par la suite, chaque fil comporte une alternance de portions passivées et de portions actives. Ceci est obtenu en ajoutant, dans certaines phases de croissance des fils du composé III-V, un précurseur d'un élément supplémentaire en excès en plus des précurseurs du composé III-V. La présence du précurseur de l'élément supplémentaire conduit à la formation d'une couche d'un matériau diélectrique sur les flancs latéraux des cristaux en croissance du composé III-V qui permet l'obtention d'une portion passivée. Dans le cas où le composé III-V est du GaN, l'élément supplémentaire peut être le silicium.

La figure 2 représente un mode de réalisation d'un dispositif optoélectronique 30. Ce dispositif est élaboré à partir de fils 31 comportant chacun une alternance de portions passivées et de portions actives, les diverses portions actives ayant toutes une hauteur inférieure au seuil de hauteur H_{S}.

Le dispositif optoélectronique 30 de la figure 2 comprend des fils 31 d'axe D et constitués de portions successives, du bas vers le haut :
une portion inférieure 32 passivée sur une hauteur H₂, recouverte d'une couche passivante 33 ;
une première portion 34, dite "portion active" ;
une deuxième portion passivée 36, revêtue d'une couche passivante 37 ;
une deuxième portion active 38 ;
une troisième portion passivée 40, revêtue d'une couche passivante 41 ;
une troisième portion active 42 ; et
une quatrième portion passivée 44, revêtue d'une couche passivante 45.

En figure 2, on a représenté trois portions actives 34, 38, 42. Toutefois, le dispositif 30 peut comprendre seulement une portion active de hauteur inférieure à H_{S}, deux portions actives ou plus de trois portions actives.

Chaque portion active 34, 38, 42 peut avoir la même structure que la portion active 24 décrite précédemment. Chaque portion passivée 32, 36, 40 et 44 peut avoir la même structure que la portion inférieure 22 décrite précédemment. En outre, chaque couche passivante 33, 37, 41 et 45 peut avoir la même structure que la couche passivante 23 décrite précédemment.

Chaque portion active 34, 38, 42 a une hauteur H₄, par exemple comprise entre 300 nm et 4 µm, et chaque portion passivée 36, 40, 44 a une hauteur H₅, par exemple comprise entre 200 nm et 10 µm. La somme des hauteurs des portions actives 34, 38, 42 et des portions passivées 36, 40, 44 est comprise entre 1 µm et 50 µm, par exemple d'environ 5 µm. Les portions actives 34, 38, 42 peuvent avoir la même hauteur comme cela est représenté en figure 2. A titre de variante, les portions actives 34, 38, 42 peuvent être de hauteurs différentes. Toutefois, dans le présent mode de réalisation, les hauteurs des portions actives 34, 38, 42 sont toutes inférieures ou égales au seuil de hauteur H_{S}. De même, les portions passivées 36, 40, 44 de hauteur H₅ peuvent avoir la même hauteur comme cela est représenté en figure 2. A titre de variante, ces hauteurs peuvent être différentes.

Les portions actives 34, 38, 42 sont revêtues de couches actives, respectivement 35, 39, 43. Chaque couche active 35, 39, 43 peut être similaire à la couche active 26 décrite précédemment. Une couche semiconductrice 47 recouvre les couches actives 35, 39, 43. La couche semiconductrice 47 peut avoir la structure de la couche 27 décrite précédemment. Des portions isolantes 48 recouvrent la face 18 entre les fils 31 sur au moins la hauteur H₂ et peuvent avoir la structure des portions isolantes 28 décrites précédemment. Une couche de seconde électrode 49 recouvre les couches semiconductrices 47 et les portions isolantes 48. La seconde électrode 49 peut avoir la structure de l'électrode 29 décrite précédemment.

En raison des hauteurs réduites des portions actives 34, 38, 42, les dépôts de couches actives 35, 39, 43 se font selon des épaisseurs et/ou des concentrations d'éléments sensiblement uniformes sur toute la hauteur de chaque portion active 34, 38, 42. Notamment, dans le cas où chaque couche active comprend une structure à puits quantiques comprenant une alternance de couches de GaN et de InGaN ou une couche unique de InGaN, la proportion d'indium est sensiblement uniforme sur toute la hauteur de chaque couche active 35, 39, 43.

Il en résulte que les longueurs d'onde d'émission liées aux couches actives 35, 39, 43 formées sur les portions actives 34, 38, 42 sont sensiblement uniformes pour chaque couche active 35, 39, 43. Par exemple, dans le cas de couches actives à base de puits quantiques multiples comprenant une alternance de couches de InGaN et de couches de GaN, chaque couche active 35, 39, 43 formée sur l'une des portions actives 34, 38, 42 d'un diamètre par exemple d'environ 2,5 µm, émet à une longueur d'onde d'environ 440 nm, ce qui correspond à une couleur bleue. On peut ainsi obtenir un spectre d'émission étroit maîtrisé avec précision.

En outre, comme il n'y a pas de couche active au sommet de chaque fil 31 qui comporte une portion passivée 44, il n'y a pas d'émission de rayonnement à une longueur d'onde différente au sommet de chaque fil 31.

Selon un autre mode de réalisation, on tire parti du fait que le dépôt de la couche active peut ne pas être identique d'une portion active à l'autre en fonction des positions de ces portions actives sur le fil, par exemple selon que la portion active est proche de la base du fil ou proche du sommet d'un fil de grande hauteur, notamment supérieure à 5 µm pour un diamètre de fil de 2 µm. Ainsi, le nombre de portions actives par fil et la hauteur de chacune d'entre elles peuvent être choisis pour obtenir le spectre d'émission ou d'absorption final souhaité. En particulier, on peut ainsi obtenir un spectre d'émission à large bande sensiblement uniforme ou proche du spectre de la lumière blanche.

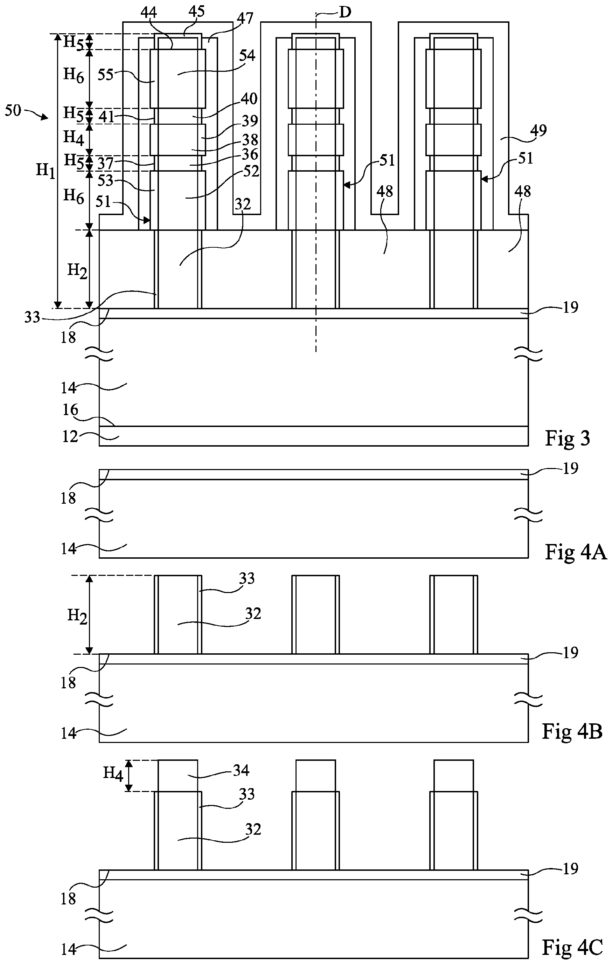

La figure 3 représente un autre mode de réalisation d'un dispositif optoélectronique 50. Ce dispositif est élaboré à partir de fils 51 comportant chacun une alternance de portions passivées et de portions actives, au moins l'une des portions actives ayant une hauteur supérieure au seuil de hauteur H_{S}. Toutes les portions actives peuvent avoir une hauteur supérieure au seuil de hauteur H_{S}. Toutefois, de préférence, au moins une autre des portions actives a une hauteur inférieure au seuil de hauteur H_{S}.

Le dispositif 50 comprend l'ensemble des éléments du dispositif optoélectronique 30 représenté en figure 2 à la différence que les portions actives 34 et 42 de la figure 2 sont remplacées par des portions actives 52 et 54 de hauteur H₆ recouverte chacune d'une couche active 53, 55. A titre d'exemple, la hauteur H₆ est strictement supérieure à la hauteur H₄, de préférence supérieure à 1,5 fois la hauteur H₄. La hauteur H₆ est, par exemple, comprise entre 5 et 7 µm.

En figure 3, on a représenté trois portions actives 52, 38, 54. Toutefois, le dispositif 50 peut comprendre seulement une, deux portions actives ou plus de trois portions actives.

Dans ce mode de réalisation, la hauteur H₆ est de préférence supérieure au seuil de hauteur au-delà duquel les phénomènes d'inégalité d'épaisseur et/ou de concentrations d'éléments de la couche active sont observés. Toutefois, le nombre de portions actives par fil et la hauteur de chacune d'entre elles peuvent être choisis pour obtenir le spectre d'émission ou d'absorption final souhaité. En particulier, on peut ainsi obtenir un spectre d'émission à large bande sensiblement uniforme ou proche du spectre de la lumière blanche.

A titre d'exemple, un spectre d'émission caractéristique d'une lumière blanche peut être obtenu en utilisant un fil comprenant une première portion active dont la hauteur est inférieure au seuil de hauteur et ayant une longueur d'onde d'émission à 590 nm et une deuxième portion active dont la hauteur est supérieure au seuil de hauteur et ayant une longueur d'onde d'émission en partie centrale de 460 nm et une longueur d'onde d'émission aux extrémités de 530 nm.

Les figures 4A à 4H illustrent les structures obtenues à des étapes successives d'un mode de réalisation d'un procédé de fabrication du dispositif optoélectronique 30 de la figure 2.

Le procédé de fabrication comprend les étapes suivantes :
(1) Traitement du substrat 14 pour favoriser la croissance de fils du composé III-V, par exemple du GaN, à des emplacements privilégiés. Ce traitement est représenté de façon schématique par la formation de la couche d'amorce 19 en surface du substrat 14 (figure 4A). L'étape (1) peut ne pas être présente. Dans ce cas, les fils peuvent croître sur le substrat 14 de façon spontanée.
(2) Croissance de la portion passivée 32 de chaque fil (figure 4B) sur la hauteur H₂ depuis la face 18 du substrat 14. La portion 32 peut être obtenue par un procédé du type MOCVD. Toutefois, des procédés tels que CVD, MBE, GSMBE, MOMBE, PAMBE, ALE, HVPE, ou électro-chimiques peuvent être utilisés.

A titre d'exemple, dans le cas où la portion 32 est en n+GaN, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950°C et 1100°C, de préférence entre 990°C et 1060°C. Pour transporter les espèces de la sortie des bulleurs aux deux plénums du réacteur, on utilise un flux de gaz porteur, par exemple du N₂, de 2000 sccm réparti dans les deux plénums.

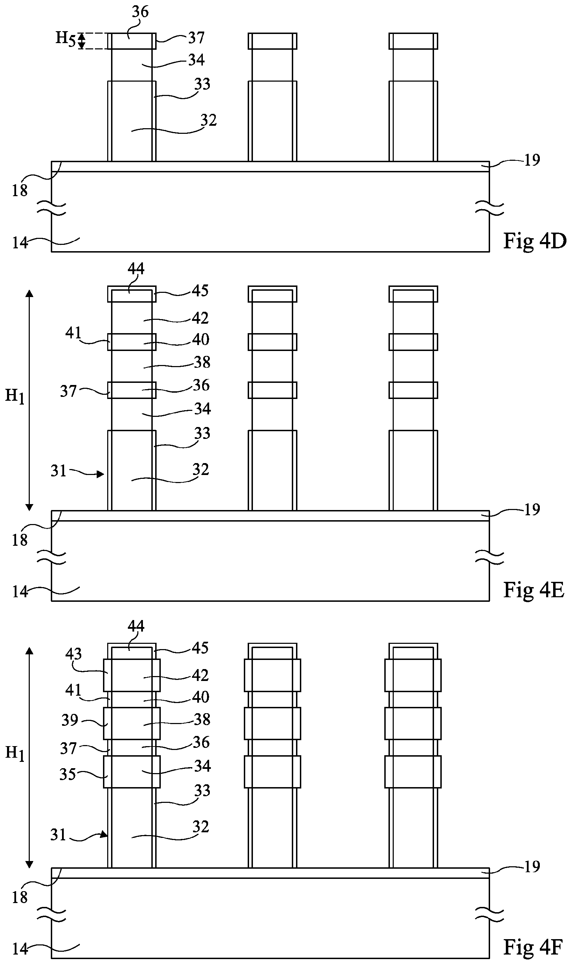

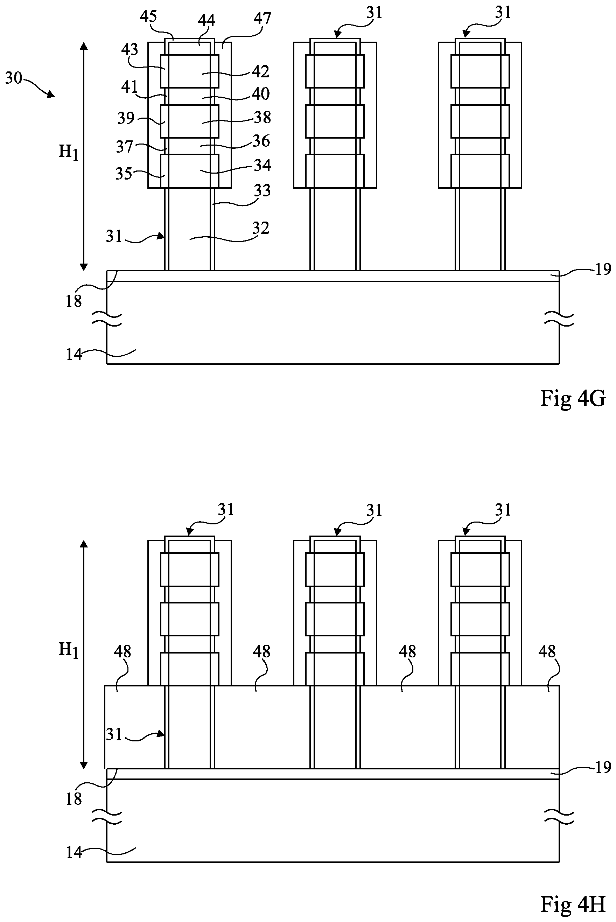

La présence de silane parmi les gaz précurseurs entraîne l'incorporation de silicium au sein du composé III-N. En outre, ceci se traduit par la formation de la couche 33 de nitrure de silicium qui recouvre le pourtour de la portion 32 de hauteur H₂, à l'exception du sommet au fur et à mesure de la croissance de la portion 32.
(3) Croissance de la portion active 34 de hauteur H₄ de chaque fil (figures 4C) sur le sommet de la portion passivée 32. Pour la croissance de la portion active 34, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, une portion active peut être dopée de type N en raison de la diffusion dans cette portion active de dopants provenant des portions passivées adjacentes ou en raison du dopage résiduel du GaN.
(4) Croissance de la portion passivée 36 de chaque fil (figure 4D) de hauteur H₅ sur le sommet de la portion active 34. Les conditions de fonctionnement du réacteur MOCVD décrites précédemment pour la croissance de la portion passivée 32 sont, à titre d'exemple, à nouveau mises en oeuvre pour la croissance de la portion 36 passivée par la couche passivante 37.
(5) Croissance successive de la portion active 38, de la portion passivée 40, de la portion active 42 et de la portion passivée 44 (figure 4E) par répétition des étapes (3) et (4).
(6) Formation par épitaxie, pour chaque fil 31, des couches actives 35, 39, 43 (figure 4F). Compte tenu de la présence des couches passivantes 33, 37, 41, 45 sur les portions passivées 32, 36, 40, 44, le dépôt des couches actives 35, 39, 43 ne se produit que sur les portions actives 34, 38, 42 du fil 31.
(7) Formation par épitaxie, pour chaque fil 31, de la couche semiconductrice 47 et, éventuellement au préalable de la couche de blocage d'électrons (figure 4G). Bien que la couche semiconductrice 47 ne croisse que sur les couches actives 35, 39, 43 et ne croisse pas directement sur les portions passivées 32, 36, 40, 44, les portions de couche semiconductrice peuvent se rejoindre pour former une seule couche semiconductrice lorsque la hauteur des portions passivées intermédiaires 36, 40 n'est pas trop importante.
(8) Formation des portions isolantes 48 (figure 4H). Les portions isolantes 48 peuvent être formées par le dépôt conforme d'une couche isolante sur la totalité de la structure représentée à la figure 4G, le dépôt d'une couche de résine entre les fils 31, la gravure de la couche isolante non recouverte par la résine pour découvrir la couche semiconductrice 47 et le retrait de la résine.

Le procédé comprend des étapes supplémentaires de réalisation des électrodes 12 et 49 pour chaque fil 31.

Le procédé de fabrication du dispositif optoélectronique 50 peut être analogue au procédé décrit précédemment en relation avec les figures 4A à 4H à la différence que les durées de croissance des portions actives sont modifiées.

Bien que les modes de réalisation décrits précédemment concernent des composés III-V, ce qui a été décrit peut également être mis en oeuvre pour la fabrication de composés II-VI (par exemple l'oxyde de zinc ZnO) comprenant un matériau semiconducteur comportant majoritairement un élément du groupe II et un élément du groupe VI.

De plus, on a représenté sur les figures des modes de réalisation dans lesquels les fils, recouverts d'une première électrode, sont formés sur une première face d'un support tandis qu'une deuxième électrode est formée sur une deuxième face du support, opposée à la première face. Toutefois, il est clair que la deuxième électrode peut être prévue du côté de la première face.

De plus, bien que, dans les modes de réalisation décrits précédemment, chaque fil comprenne une portion passivée 32, à la base du fil en contact avec la face 18, cette portion passivée 32 peut ne pas être présente.

De plus, bien que les modes de réalisation décrits précédemment comprennent des portions isolantes 28, 48 entre les fils, ces portions isolantes peuvent ne pas être présentes.

De plus, on a représenté en figures 2 et 3 trois portions actives susceptibles d'être revêtues de couches actives. Ce nombre de régions peut être réduit ou multiplié.

De plus, si les différents modes de réalisation de dispositifs optoélectroniques décrits précédemment sont adaptés pour émettre un rayonnement électromagnétique, de tels dispositifs peuvent aisément être adaptés par un homme du métier pour recevoir un rayonnement électromagnétique et le convertir en un signal électrique. Une telle adaptation est réalisée en adaptant à la fois la couche active 35, 39, 43, 53, 55 de chacun des fils 31, 51 et en appliquant sur la structure semiconductrice une polarisation adéquate. Une telle adaptation du dispositif 30, 50 peut être réalisée pour former soit un dispositif optoélectronique dédié à la mesure ou la détection d'un rayonnement électromagnétique, soit un dispositif optoélectronique dédié aux applications photovoltaïques.

## Revendications

1. Dispositif optoélectronique (30 ; 50) comprenant des microfils ou nanofils comportant majoritairement un composé III-V dont chacun comprend une alternance de portions passivées (32, 36, 40, 44) et de portions actives (34, 38, 42 ; 52, 54), chaque portion active étant entourée, à la périphérie du microfil ou nanofil, d'une couche active (35, 39, 43 ; 53, 55), les couches actives ne s'étendant pas sur les portions passivées, les couches actives étant les couches depuis lesquelles est émise la majorité du rayonnement fournie par le dispositif, le nombre de portions actives par microfils ou nanofils et la hauteur de chacune d'entre elles étant choisis pour obtenir le spectre d'émission souhaité du dispositif optoélectronique.

2. Dispositif selon la revendication 1, dans lequel les hauteurs des portions actives (52, 38, 54) sont différentes.

3. Dispositif selon la revendication 1, dans lequel les hauteurs des portions actives (34, 38, 42) sont égales.

4. Dispositif selon l'une quelconque des revendications 1 à 3, dans lequel au moins l'une des portions actives (52, 54) a une hauteur supérieure ou égale à 4 µm.

5. Dispositif selon l'une quelconque des revendications 1 à 4, dans lequel au moins l'une des portions actives (34, 38, 42) a une hauteur strictement inférieure à 5 µm.

6. Dispositif selon l'une quelconque des revendications 1 à 5, dans lequel la hauteur de chaque portion passivée (32, 36, 40, 44) intercalée entre deux portions actives (34, 38, 42 ; 52, 54) est comprise entre 200 nm et 10 µm.

7. Dispositif selon l'une quelconque des revendications 1 à 6, dans lequel chaque portion passivée (32, 36, 40, 44) est entourée d'une couche (33, 37, 41, 45) de matériau diélectrique ayant une épaisseur comprise entre une monocouche atomique et 10 nm.

8. Dispositif selon l'une quelconque des revendications 1 à 7, dans lequel les portions passivées et actives (32, 36, 40, 44, 34, 38, 42 ; 52, 54) ont le même diamètre moyen.

9. Dispositif selon l'une quelconque des revendications 1 à 8, dans lequel les portions passivées et actives (32, 36, 40, 44, 34, 38, 42 ; 52, 54) ont des diamètres différents.

10. Dispositif selon l'une quelconque des revendications 1 à 9, dans lequel les portions passivées (32, 36, 40, 44) comprennent un composé III-V dopé, les portions actives (34, 38, 42 ; 52, 54) comprenant majoritairement un composé III-V non dopé ou moins fortement dopé que les portions passivées.

11. Dispositif selon la revendication 10, dans lequel le composé III-V est un composé III-N, notamment choisi parmi le groupe comprenant le nitrure de gallium, le nitrure d'aluminium, le nitrure d'indium, le nitrure de gallium et d'indium, le nitrure de gallium et d'aluminium, le nitrure d'aluminium et d'indium et le nitrure de gallium, d'aluminium et d'indium.

12. Dispositif selon la revendication 10, dans lequel le composé III-V est du nitrure de gallium et le dopant du composé III-V dopé est du silicium.

13. Dispositif selon l'une quelconque des revendications 1 à 12, dans lequel la portion la plus éloignée du support (14) est une portion passivée (44).

14. Dispositif selon l'une quelconque des revendications 1 à 13, dans lequel chaque couche active (35, 39, 43 ; 53, 55) comprend une structure à puits quantiques multiples ou simple couche.

15. Procédé de fabrication d'un dispositif optoélectronique selon l'une quelconque des revendications 1 à 14, dans lequel les portions passivées (32, 36, 40, 44) sont réalisées dans un réacteur avec des premières proportions de précurseurs de composés III-V et un dopant tel que le silicium, et dans lequel les portions actives (34, 38, 42 ; 52, 54) sont réalisées dans le même réacteur dans des conditions différentes de croissance et avec un taux de dopant plus faible que celui des portions passivées ou nul.

## Patentansprüche

1. Optoelektronisches Bauteil (30; 50) mit Mikro- oder Nanostäbchen, die hauptsächlich eine III-V-Verbindung aufweisen, wobei jede Verbindung eine Alternation von passivierten Teilen (32, 36, 40, 44) und von aktiven Teilen (34, 38, 42; 52, 54) aufweist,
wobei jeder aktive Teil umgeben ist, und zwar am Randbereich des Mikro- oder Nanostäbchens, mit einer aktiven Schicht (35, 39, 43; 53, 55),
wobei die aktiven Schichten nicht auf die passivierten Teile ragen,
wobei die aktiven Schichten diejenigen Schichten sind, von denen die meiste Strahlung, die vom Bauteil bereitgestellt wird, abstrahlt wird,
wobei die Anzahl aktiver Teile pro Mikro- oder Nanostäbchen und deren jeweilige Höhe entsprechend ausgewählt werden, um das erwünschte Abstrahlungsspektrum des optoelektronischen Bauteils zu erhalten.

2. Das Bauteil nach Anspruch 1, wobei die Höhen der aktiven Teile (52, 38, 54) unterschiedlich sind.

3. Das Bauteil nach Anspruch 1, wobei die Höhen der aktiven Teile (34, 38, 42) gleich sind.

4. Das Bauteil nach einem der Ansprüche 1 bis 3, wobei mindestens einer der aktiven Teile (52, 54) eine Höhe hat, die größer oder gleich 4 µm ist.

5. Das Bauteil nach einem der Ansprüche 1 bis 4, wobei mindestens einer der aktiven Teile (34, 38, 42) eine Höhe hat, die kleiner als 5 µm ist.

6. Das Bauteil nach einem der Ansprüche 1 bis 5, wobei die Höhe jedes passivierten Teils (32, 36, 40, 44), der zwischen zwei aktiven Teilen (34, 38, 42; 52, 54) eingeschoben ist, im Rahmen von 200 nm bis 10 µm liegt.

7. Das Bauteil nach einem der Ansprüche 1 bis 6, wobei jeder passivierte Teil (32, 36, 40, 44) mit einer Schicht (33, 37, 41, 45) aus dielektrischem Material umgeben ist, das eine Dicke im Rahmen von einer atomaren Monolage bis zu 10 nm hat.

8. Das Bauteil nach einem der Ansprüche 1 bis 7, wobei die passivierten und aktiven Teile (32, 36, 40, 44, 34, 38, 42; 52, 54) den gleichen durchschnittlichen Durchmesser haben.

9. Das Bauteil nach einem der Ansprüche 1 bis 8, wobei die passivierten und aktiven Teile (32, 36, 40, 44, 34, 38, 42; 52, 54) unterschiedliche Durchmesser haben.

10. Das Bauteil nach einem der Ansprüche 1 bis 9, wobei die passivierten Teile (32, 36, 40, 44) eine dotierten III-V-Verbindung aufweisen, wobei die aktiven Teile (34, 38, 42; 52, 54) hauptsächlich eine III-V-Verbindung aufweisen, die nicht dotiert oder weniger stark dotiert ist als die passivierten Teile.

11. Das Bauteil nach Anspruch 10, wobei die III-V-Verbindung eine III-N-Verbindung ist, insbesondere ausgewählt aus der Gruppe aus Galliumnitrid Aluminiumnitrid, Indiumnitrid, Galliumindiumnitrid, Galliumaluminiumnitrid, Aluminiumindiumnitrid und Galliumaluminiumindiumnitrid.

12. Das Bauteil nach Anspruch 10, wobei die III-V-Verbindung Galliumnitrid ist und wobei der Dotand der dotierten III-V-Verbindung Silizium ist.

13. Das Bauteil nach einem der Ansprüche 1 bis 12, wobei der Teil, der sich am entferntesten bezüglich der Auflage (14) befindet, ein passivierter Teil (44) ist.

14. Das Bauteil nach einem der Ansprüche 1 bis 13, wobei jede aktive Schicht (35, 39, 43; 53, 55) eine multiple Quantentopf- oder Einzelschichtstruktur aufweist.

15. Verfahren zur Herstellung des optoelektronischen Bauteils nach einem der Ansprüche 1 bis 14, wobei die passivierten Teile (32, 36, 40, 44) in einem Reaktor geformt werden, und zwar mit ersten Anteilen von Präkursoren der III-V-Verbindungen und einem Dotanden wie beispielsweise Silizium, und wobei die aktiven Teile (34, 38, 42; 52, 54) im gleichen Reaktor unter unterschiedlichen Wachstumsbedingungen und mit einer Dotierrate geformt werden, die kleiner als jene der passivierten Teile oder gleich null ist.

## Claims

1. An optoelectronic device (30; 50) comprising microwires or nanowires mainly comprising a III-V compound, each of which comprises an alternation of passivated portions (32, 36, 40, 44) and of active portions (34, 38, 42; 52, 54), each active portion being surrounded, at the periphery of the microwire or nanowire, with an active layer (35, 39, 43; 53, 55), where the active layers do not extend on the passivated portions, the active layers being the layers from which most of the radiation provided by the device is emitted, the number of active portions per microwire or nanowire and the height of each one of them being chosen to obtain the desired emission spectrum of the optoelectronic device.

2. The device of claim 1, wherein the heights of the active portions (52, 38, 54) are different.

3. The device of claim 1, wherein the heights of the active portions (34, 38, 42) are equal.

4. The device of any of claims 1 to 3, wherein at least one of the active portions (52, 54) has a height greater than or equal to 4 µm.

5. The device of any of claims 1 to 4, wherein at least one of the active portions (34, 38, 42) has a height smaller than 5 µm.

6. The device of any of claims 1 to 5, wherein the height of each passivated portion (32, 36, 40, 44) interposed between two active portions (34, 38, 42; 52, 54) is in the range from 200 nm to 10 µm.

7. The device of any of claims 1 to 6, wherein each passivated portion (32, 36, 40, 44) is surrounded with a layer (33, 37, 41, 45) of dielectric material having a thickness in the range from one atomic monolayer to 10 nm.

8. The device of any of claims 1 to 7, wherein the passivated and active portions (32, 36, 40, 44, 34, 38, 42; 52, 54) have the same average diameter.

9. The device of any of claims 1 to 8, wherein the passivated and active portions (32, 36, 40, 44, 34, 38, 42; 52, 54) have different diameters.

10. The device of any of claims 1 to 9, wherein the passivated portions (32, 36, 40, 44) comprise a doped III-V compound, the active portions (34, 38, 42; 52, 54) mainly comprising a III-V compound which is undoped or less heavily doped than the passivated portions.

11. The device of claim 10, wherein the III-V compound is a III-N compound, particularly selected from the group comprising gallium nitride, aluminum nitride, indium nitride, gallium indium nitride, gallium aluminum nitride, aluminum indium nitride, and gallium aluminum indium nitride.

12. The device of claim 10, wherein the III-V compound is gallium nitride and the dopant of the doped III-V compound is silicon.

13. The device of any of claims 1 to 12, wherein the portion most distant from the support (14) is a passivated portion (44).

14. The device of any of claims 1 to 13, wherein each active layer (35, 39, 43; 53, 55) comprises a multiple quantum well or single layer structure.

15. A method of manufacturing the optoelectronic device of any of claims 1 to 14, wherein the passivated portions (32, 36, 40, 44) are formed in a reactor with first proportions of precursors of III-V compounds and a dopant such as silicon, and wherein the active portions (34, 38, 42; 52, 54) are formed in the same reactor in different growth conditions and with a dopant rate smaller than that of the passivated portions or equal to zero.
